Europäisches Patentamt

European Patent Office

Office européen des brevets

(19)

(11) Publication number: **0 145 320**
**A2**

(12) **EUROPEAN PATENT APPLICATION**

(21) Application number: **84307890.8**

(51) Int. Cl.⁴: **G 11 C 7/00**

(22) Date of filing: **14.11.84**

(30) Priority: **15.11.83 US 551813**

(43) Date of publication of application: **19.06.85**
**Bulletin 85/25**

(84) Designated Contracting States: **DE FR GB IT NL**

(71) Applicant: **MOTOROLA, INC., 1303 East Algonquin Road, Schaumburg, Illinois 60196 (US)**

(72) Inventor: **Gustin, Jay W., 6226 E. Joan de Arc, Scottsdale Arizona 85254 (US)**

(74) Representative: **Hudson, Peter David, Motorola Ltd. Patent and Licensing Operations - Europe Jays Close Viables Industrial Estate, Basingstoke Hampshire RG22 4PD (GB)**

(54) **Method for multiplexing a memory data bus.**

(57) The amount of data obtained from parallel connected memories is increased by using the column precharge time of one of the memories to access data from another one of the memory devices. By having the memory devices connected in parallel they each receive the same address and the same row address strobe. The column address of one of the first memories is then strobed in by the column address strobe signal and data is accessed from this first memory. Then while the first memory's columns are being precharged the column address strobe signal is activated for a second memory and data is obtained from the second memory. The procedure can be repeated so that after the second memory's data is retrieved the second column address strobe signal is inactivated so that the columns of the second memory can be precharged at the same time a new column address is strobed into the first memory. Thus, memory bandwidth is increased without the need to widen the memory data bus.

METHOD FOR MULTIPLEXING A MEMORY DATA BUS

Background of the Invention

This invention relates, in general, to memories, and more particularly, to a method for multiplexing data from random access memories.

Raster graphics display systems, especially those with multiple colors and/or high resolution, need high bandwidth memory and/or large memory data bus widths to produce enough bits to describe a pixel on the display screen. Pixel is the smallest picture element on the display that can be controlled by the data in memory. The horizontal and vertical screen resolutions set the limit on a graphics display system resolution and is usually picked to match the cathode ray tube resolution. Dynamic RAMs are well suited for use in raster graphics display systems due to their large storage capacity and low cost. The access time of dynamic RAMs, however, requires large data widths to obtain enough data in a memory fetch cycle. Memory throughput can be increased by using a technique called "page" mode. This scheme takes advantage of the internal addressing method of the dynamic RAM for speed advantage. These types of RAMs have multiplex address busses. The internal array of the RAM is composed of rows and columns of storage cells. To address the RAM, the row address is first strobed into the memory chip on the row address strobe (RAS) signal. The column address is then placed on the address pins of the memory chip and strobed in by the column address strobe (CAS) signal. In the page mode operation, the row address is strobed with RAS as before and then the column address is strobed in with CAS as before. Both RAS and CAS are held low until the data becomes valid then the CAS line is raised high and another column address is presented to the memory chip; the CAS line is then brought low to strobe in the new column address. The period of time the CAS is held high between page mode accesses is called the column precharge time. Although the page mode has been successfully used to increase the data throughput of a memory it would be desirable to have a technique for further increasing the throughput from parallel connected memories.

Accordingly, it is an object of the present invention to provide an improved method for multiplexing a memory data bus.

Another object of the present invention is to provide a method for increasing the throughput of parallel connected memories.

A further object of the present invention is to provide a method for multiplexing the data bus of a memory which permits using the same memory timing for eight or sixteen bit bus systems.

Yet a further object of the present invention is to provide a method for increasing memory bandwidth which allows the use of higher access time and lower cost memories.

Yet another object of the present invention is to use the column precharge time of one memory to access a companion parallel connected memory.

Yet another further object of the present invention is to provide a method for doubling the amount of data accessed from a memory system without having to double the bandwidth of the memories being used or having to add external controls.

## Summary of the Invention

The above and other objects and advantages of the present invention are provided by a method for accessing parallel connected memories. In a memory system having parallel connected memories all of the I/O signals of the parallel connected memories, except CAS, are connected to each of the memories. Thus, a second memory gets the same row address and the same column address as a first memory. The difference is that the CAS of the second memory is delayed until the first memory data is read. Then the second memory CAS line is activated and the additional data is retrieved from the second memory. After the second memory's data is retrieved, the second CAS signal is brought high and held for a precharge time. At the same time, a new address is strobed into the first memory with the first CAS signal to again access data from the first memory.

## Brief Description of the Drawings

FIG. 1 illustrates in block diagram form a system suitable for practicing the present invention; and

FIG. 2 is a timing diagram showing some memory signals which are useful in understanding the present invention.

## Detailed Description of the Drawings

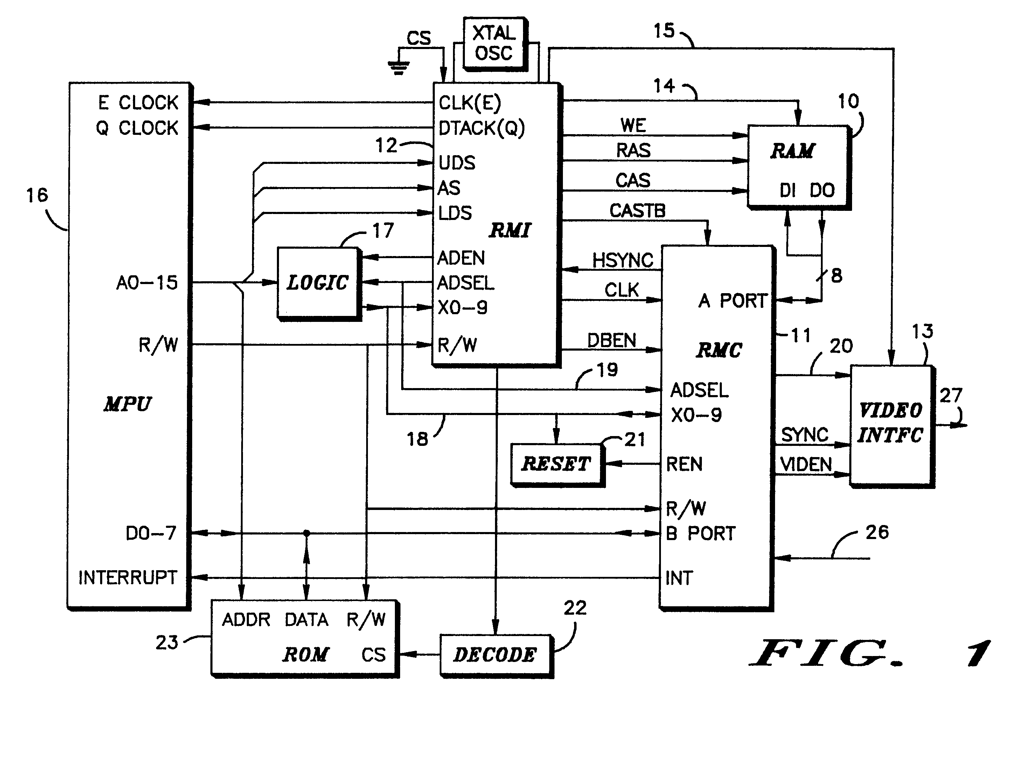

There are many video display or raster graphics display systems. Most such systems use a plurality of memories connected in parallel and arranged in banks. FIG. 1 illustrates one such video display system which is useful in understanding the application of the present invention. RAM 10 represents a bank of from one to four dynamic RAMs which are connected to an 8 bit data bus going to an A port of raster memory control (RMC) 11. RAM 10 receives its addresses on Z bus 14 which is connected to raster memory interface (RMI) 12. RMI 12 also provides row address strobe (RAS) signal, write enable signal (WE), and column address strobe (CAS) signals to RAM 10. Since RAM 10 represents a plurality of random access memories connected in parallel, only one write enable and one row address strobe line is provided while the number of column address strobe lines is equal to the number of RAMs.  RMI 12 also provides the color sub carrier signal on line 15 to video interface circuit 13.  Video interface circuit 13 also receives sync and video enable (VIDEN) signals along with red, green, and blue color signals from RMC 11.  The red, green, and blue color signals are coupled from RMC 11 to video interface circuit 13 on line 20.  Video interface circuit 13 provides a video output signal on line 27.  RMC 11 receives an input signal on line 26 from a light pen.  A microprocessor 16 is interconnected with RMI 12, RMC 11, logic circuitry 17, and a read only memory (ROM) 23.  Logic circuitry 17 is also connected to a reset circuit 21 and to RMC 11 by X bus 18.  A chip select decode circuit 22 receives a signal from RMI 12 and provides a chip select output to ROM 23.

Microprocessor 16 receives the basic MPU clock signal, shown as E clock, from RMI 12 and also receives a data acknowledge (DTACK) signal from RMI 12.  The microprocessor unit illustrated as MPU 16 uses the data acknowledge signal as a Q clock.  MPU 16 provides an upper data strobe (UDS) signal, an address strobe (AS), and a lower data strobe (LDS) signal to RMI 12.  MPU 16 also provides address signals to logic circuit 17 and to ROM 23.  Logic circuit 17 receives an address enable (ADEN) and an address select (ADSEL) signal from RMI 12, and provides address signals to RMI 12 and to RMC 11 on line 18.  These address signals also go to reset circuit 21.  Reset circuit 21 receives a reset enable (REN) signal from RMC 11.  The address select signal provided by RMI 12 is also connected to RMC 11 by line 19.  RMI 12 also provides a data bus enable (DBEN) signal along with several clock signals to RMC 11.  RMC 11 provides a horizontal sync (HSYNC) signal to RMI 12 and receives a CAS strobe signal (CASTB).  The CAS strobe signal is a composite of the CAS signals and changes state with each change of state of the CAS signals during the display portion of the memory cycle and is used to strobe display data from RAM 10 into RMC 11.  RMC 11 provides an interrupt signal to MPU 16 and receives a read/write command signal from MPU 16.  The read/write (R/W) signal also goes to ROM 23 and RMI 12.  Data is transferred on the B port line of RMC 11 to ROM 23 and MPU 16.  RMI 12 has a chip select (CS) line which is connected to ground and receives a crystal oscillator input which is used as the basic timing for the system.

In a preferred embodiment, the system illustrated in FIG. 1 would use an M6809E microprocessor 16, which is made and sold by Motorola Inc.  Logic circuit 17 is, in a preferred embodiment, a 74ALS logic circuit which is also made and sold by Motorola Inc.  However, as stated hereinbefore FIG. 1 is just illustrative of the type of system which could use the present invention.  The present invention can be used to multiplex data from two memory systems onto a single bus.  The data multiplexed can result in a byte twice or four times as long as a byte from a single memory system.  A byte is a single group of data bits processed together and contains a predetermined number of bits.  The number of bits will vary depending on the microprocessor used and the bus width.

The present invention is useful in any system where at least two RAMs are connected in parallel wherein each of the parallel connected RAMs receives its own individual column address strobe (CAS) signal.  In some systems such as raster graphics display systems it is essential that the RAMs be organized into banks and then the banks connected in parallel to provide the necessary memory capacity required for such a system.  In such a case, the number of memories in the bank will correspond to the number of bits carried by the data bus.  As an example, an 8 bit memory bus will have a bank of eight RAMs connected to it.  To make maximum use of the present invention a second bank of eight RAMs would also be connected to the data bus.  During the data access period the row address strobe (RAS) signal would be activated for all the memories in both banks. Then the column address strobe (CAS) signal would be activated for the first bank and the data from the first bank would be passed to the data bus. During the inactivation of the CAS signal for the first bank the column lines of the first bank are precharged, and at the same time the CAS signal for the second bank is activated and data from the second bank is passed to the data bus. In this manner the data bus would be carrying a 16 bit wide word. If the procedure is repeated again for the first bank while the column lines of the second bank are being precharged followed by accessing data from the second bank while the column lines of the first bank are being precharged the data bus will appear to be carrying a 32 bit wide word. This same scheme can be used with microprocessor units having 16 bit data busses such as Motorola's M68000 microprocessor.

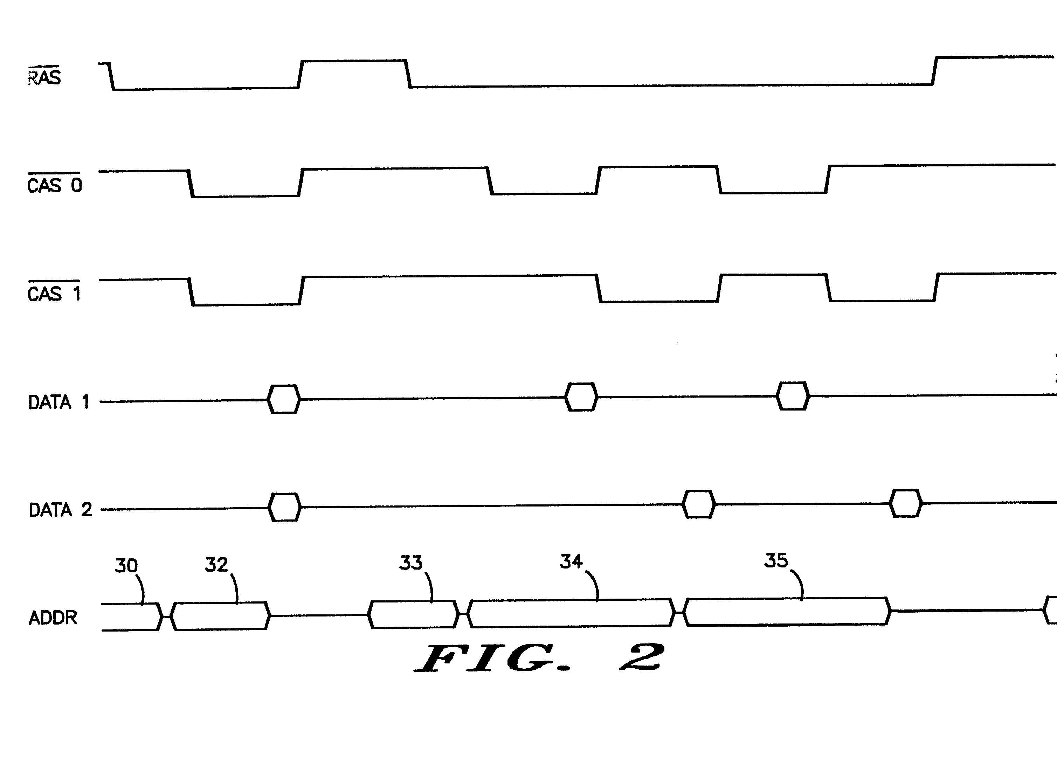

The method of operation of the present invention is graphically illustrated by the timing waveforms shown in FIG. 2. The top waveform labeled $\overline{RAS}$ is a row address strobe signal. The second signal labeled $\overline{CAS}$ 0 is a column address signal for the first memory or the first bank of memories. The third signal is labeled $\overline{CAS}$ 1 and is the column address strobe signal for the second memory or the second bank of memories. The next two waveforms are labeled DATA 1 and DATA 2 respectively and illustrate when the data bus is carrying the respective valid data. The last waveform illustrates the addresses for the memories. The memories are shared by the MPU and by the display screen. Accordingly, note that valid addresses indicated by reference numerals 30 and 32 are directed to MPU functions. The valid addresses indicated by reference numeral 33 are the display row addresses at which time $\overline{RAS}$ becomes active by going to a low level. $\overline{RAS}$ remains low for the duration of time that display data is being accessed from the memories. During the period of time indicated by reference numeral 34 a display column address to the first memory or memory bank is valid at which time $\overline{CAS}$ 0 becomes active by going to a low level. $\overline{CAS}$ 0 then goes to a high level so that the columns of the first memory or memory bank can be precharged and simultaneously $\overline{CAS}$ 1 goes to a low level to strobe in the first set of display column addresses for the second memory or the second memory bank. When $\overline{CAS}$ 1 goes to a high level then $\overline{CAS}$ 0 goes to a low level thereby strobing in the second set of display column addresses for the first memory or memory bank. When $\overline{CAS}$ 0 goes high so that the columns can be precharged $\overline{CAS}$ 1 goes low to strobe in the second set of addresses to the second memory. Notice how the data is valid at the end of each column address strobe signal. The data from the first memory or the first bank of memories is shown as DATA 1 while the data from the second memory or the second bank of memories is shown as DATA 2. This method of multiplexing the memory data bus allows the same memory timing for an 8 bit or a 16 bit bus system. This method also provides increased memory bandwidth, allows use of higher access time, and the use of lower cost memories. The random access memories used have internal output enables thereby eliminating the need for an external multiplexer or tristate buffer. This invention utilizes the page mode access to increase the speed of obtaining data from a memory system. Access to two banks of memories are alternated so that one 8 bit bus can access the equivalent of 16 bits in a display fetch, or one 16 bus can access 32 bits. It will be understood that this technique can be expanded to access yet additional bits of data. By using the column precharge time of one bank of memories to access data from the other bank of memories provides a doubling in the amount of data accessed without doubling the bus bandwidth or adding external controls or multiplexing.

By now it should be appreciated that the method of the present invention can be extended to any number of memory devices arranged to produce an 8, a 16, or more bit data bus. In a raster graphics display system, an 8 bit data bus using this memory access concept produces 32 bits of graphic data using 150 nanosecond access time RAMs in the same amount of time it takes to obtain 24 bits of data using just page mode and 120 nanosecond access RAMs. Therefore, memory bandwidth is increased without the need to widen the memory data bus.

Although the present invention has been described in conjunction with dynamic RAMs, it will be recognized that the principles apply to any type of memory having the necessary control signals. The invention offers the greatest advantage with memory banks or with memories that output more than one bit at a time. It can also be used with memories that output only one bit at a time.

CLAIMS

1. A method for increasing the amount of data accessed from a first and a second bank of memories within a given period of time comprising: accessing data from the first memory bank; precharging the first memory bank; and accessing data from the second memory bank during the precharging of the first memory bank.

2. The method of claim 1 further including placing the accessed data from both memory banks on the same bus so that the accessed data is equivalent to a byte twice as long as a byte from a single bank of memories.

3. A method of increasing bandwidth of at least a first and a second memory which are connected to receive a plurality of common signals from an input/output device except for a column address strobe (CAS) which each memory receives separately, the method comprising: strobing in column addresses for the first memory; strobing in column addresses for the second memory after data addressed in the first memory is read; and precharging the first memory during the time that the column addresses are being strobed into the second memory.

4. A method for increasing memory bandwidth for two memory banks connected in parallel and having a common row address strobe and separate column address strobes, comprising: activating the column address strobe for a first of the two memories; activating the column address strobe for the second of the two memories upon completion of the activation of the column address strobe for the first memory; precharging the first memory during activation of the column address strobe for the second memory; reactivating the column address strobe for the first memory upon completion of the activation of the column address strobe of the second memory; precharging the second memory during reactivation of the column address strobe for the first memory; and reactivating the column address strobe of the second memory upon completion of the reactivation of the column address strobe for the first memory.

FIG. 1

0145320

RAS

CAS 0

CAS 1

DATA 1

DATA 2

ADDR

30

32

33

34

35

*FIG. 2*